# EUROPEAN PATENT APPLICATION

(11) **EP 4 682 947 A1**
(43) Date of publication of application: **21.01.2026**
(21) Application number: 24189650.5
(22) Date of filing: 19.07.2024
(51) Int. Cl.: H01L 21/687, G03F 7/00

(54) **SUBSTRATE SUPPORT, METHOD FOR LOADING A SUBSTRATE ON A SUBSTRATE SUPPORT AND LITHOGRAPHIC APPARATUS**

(71) Applicant: ASML Netherlands B.V., 5500 AH Veldhoven (NL)
(72) Inventor: EGGELS, Eva Hanna, 5500 AH Veldhoven (NL); BERGHOUT, Pieter, 5500 AH Veldhoven (NL); HARBERTS, Dirk Willem, 5500 AH Veldhoven (NL)
(74) Representative: ASML Netherlands B.V.

(57) **Abstract**

The present invention provides a substrate support comprising:
a clamp body comprising a plurality of protrusions, the plurality of protrusions defining a support plane to support the substrate,
a first clamp to attract the substrate on the clamp body in a first clamping direction,
a circumferential support element comprising a peripheral set of protrusions to support an edge region of the substrate, wherein the circumferential support element is movable with respect to the clamp body in a direction at least perpendicular to the support plane,
a second clamp to attract the circumferential support element in a second clamping direction opposite to the first clamping direction such that the peripheral set of protrusions will be moved in the direction of or against the edge region of the substrate supported on the substrate support to support the edge region during use.

## Description

### FIELD

The present invention relates to a substrate support, a method for loading a substrate on such substrate support, and a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In EUV lithographic apparatus a substrate support with an electrostatic clamp may be provided to clamp a substrate on the substrate support with an electrostatic force. The electrostatic force of the electrostatic clamp is provided to bring and hold the substrate on the substrate support in a flat state. The clamp body of the substrate support may be provided with protrusions that define a support plane on which the substate is supported. The protrusions may substantially reduce the surface area of the substrate which actually contacts the clamp body when supported on the protrusions. The contact surface may be substantially less than the surface area of the substrate. This reduced contact surface area may reduce van der Waals sticking and the probability of contamination, of for example particles, trapped between the substrate and the clamp body.

The backside of a substrate, i.e. the side on which the substrate is supported on the substrate support, is usually coated with a backside coating. This backside coating is intended to have a constant thickness over the surface area of the substrate. However, due to the coating process, the thickness of the coating in an edge region of the substrate may deviate from the desired thickness of the coating of the substrate. As a result, protrusions intended to support the edge region of the substrate and having the same height as protrusions supporting a center part of the substrate, may not support the substrate at the desired height, which typically may result in sagging of the substrate at the edge region.

Support of the edge region of the substrate is further complicated by warped shapes of substrates to be supported on the substrate support, in particular for warped edges of the substrate.

### SUMMARY

It is an object of the invention to provide a substrate support that provides improved support of an edge region of the substrate. Other objects of the invention are to provide a method for loading a substrate on the substrate support and/or a lithographic apparatus having an improved substrate support.

According to a first aspect of the invention there is provided a substrate support comprising:
a clamp body comprising a plurality of protrusions, the plurality of protrusions defining a support plane to support the substrate,
a first clamp to attract the substrate on the clamp body in a first clamping direction,
a circumferential support element comprising a peripheral set of protrusions to support an edge region of the substrate, wherein the circumferential support element is movable with respect to the clamp body in a direction at least perpendicular to the support plane,
a second clamp to attract the circumferential support element in a second clamping direction opposite to the first clamping direction such that the peripheral set of protrusions will be moved in the direction of or against the edge region of the substrate supported on the substrate support to support the edge region during use. The substrate support may be configured for use in a lithographic apparatus or in a lithographic tool.

According to a second aspect of the invention there is provided a method for loading a substrate on such substrate support, comprising:
arranging the substrate on the clamp body,
actuating the first clamp to clamp the substrate on the plurality of protrusion, and
actuating the second clamp to attract the circumferential support element to support the edge region of the substrate with the peripheral set of protrusions.

According to a third aspect of the invention there is provided a lithographic apparatus comprising the substrate support according to the first aspect of the invention.

According to a fourth aspect of the invention there is provided a lithographic tool, such as a metrology apparatus, comprising the substrate support according to the first aspect of the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts schematically a substrate support according to an embodiment of the invention;
- Figure 3 depicts detail A of the substrate support of Figure 2;
- Figure 4 depicts schematically a top view of the substrate support of Figure 2; and

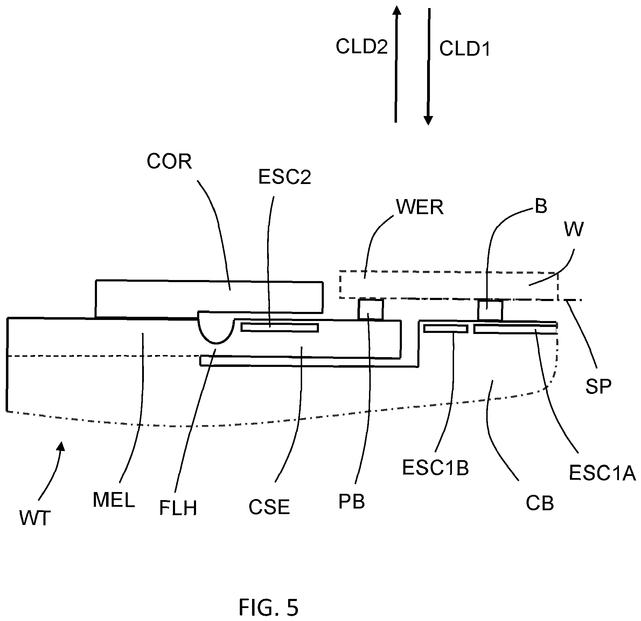

- Figure 5 depicts detail A of a substrate support according to an alternative embodiment of the invention.

### DETAILED DESCRIPTION

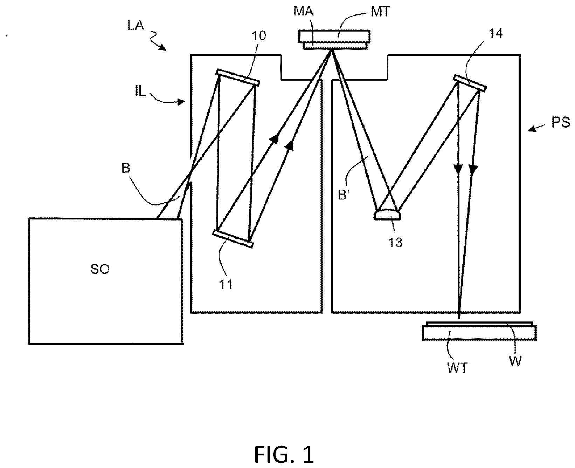

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

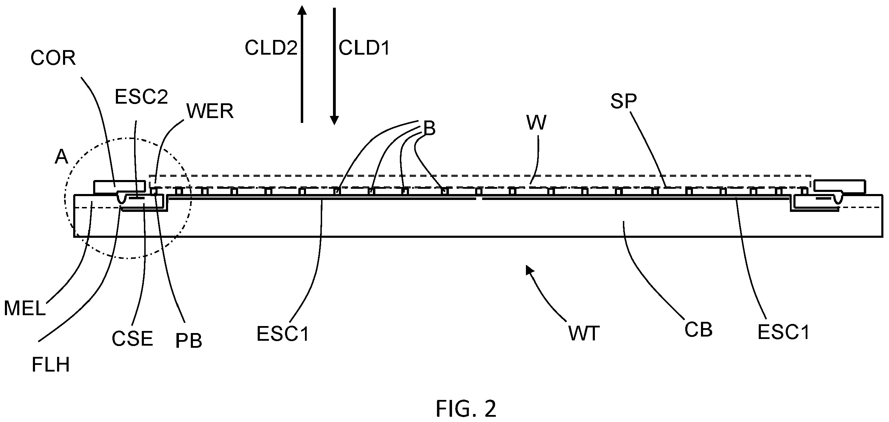

Figure 2 shows a part of the substrate support WT, for example a substrate table, that may be used in the lithographic apparatus LA of Figure 1 to support a substrate W. The substrate support WT comprises a clamp body CB comprising a plurality of protrusions B, in the form of burls. The plurality of protrusions B define a support plane SP in which the substrate W may be supported. The clamp body CB may be formed from a number of layers arranged, for example bonded, on top of each other. These layers may comprise a core body and one or more dielectric layers and/or isolating layers. The core body may for example comprise glass layers and/or ceramic layers.

Although not shown in the figures, a bottom side of the clamp body SB may be configured to be placed on a further support structure, such as a mirror block. The bottom side may comprise burls and a clamping system, for example an electrostatic clamp to clamp the clamp body on the support structure arranged below the clamp body.

Lifting pins (not shown) may be provided to lift a substrate W from the clamp body CB towards a position spaced from and above the support plane SP to allow a gripper to take the substrate W from the substrate support WT. Correspondingly, a substrate W can be loaded from the gripper on the substrate support WT by placing the substrate W on the lifted lifting pins, and by subsequently lowering the lifting pins to place the substrate on the protrusions B of the clamp body CB.

A first set of electrodes ESC1 of a first electrostatic clamp may be provided to attract the substrate W with a first electrostatic clamping force in a first clamping direction CLD1 on the clamp body CB, in particular on the upper ends of the protrusions B of the clamp body CB. The first set of electrodes ESC1 may comprise two half circle shaped electrodes ESC1; a positive electrode and a negative electrode. The electrodes of the first set of electrodes ESC1 may be embedded within the clamp body CB as shown. It is noted that any conductors required to connect electrodes to a voltage source are not shown in the figures of this application.

The advantage of the protrusions B is that the protrusions B may substantially reduce the surface area of the substrate W which actually contacts the clamp body CB when supported on the protrusions B. This contact surface may be substantially less than the surface area of the backside of the substrate W. This reduced contact surface area may reduce van der Waals sticking and the probability of contamination, of for example particles, trapped between the substrate and the clamp body CB.

The backside of a substrate, i.e. the side on which the substrate is supported on the substrate support, is usually coated with a backside coating. This backside coating is intended to have a constant thickness over the surface area of the substrate. However, due to the coating process, the thickness of the coating in an edge region of the substrate W may deviate from the desired thickness of the coating of the substrate W. As a result, if protrusions intended to support an edge region WER of the substrate W would be provided, the substrate W may not be supported at the same height.

Therefore, a known substrate support is constructed without protrusions to support the edge region WER of the substrate W. For example, in a known embodiment of a substrate support for a substrate W having a diameter of 300 mm, the most outer protrusions may be arranged at a radius of about 146.5 mm from the center of the substrate W. This result in a circumferential edge region of about 3.5 mm which is not supported by the protrusions of the clamp body. This unsupported edge region may sag during use. This may result in a decreased overlay and/or focus performance in the edge region WER of the substrate W.

Support of the edge region WER of the substrate may be further complicated by warped shapes of substrates to be supported on the substrate support, in particular for warped edges of the substrate, i.e. substantial height differences in the edge region WER of the substrate W and/or between the edge region and the center of the substrate.

In the embodiment of Figure 2, a circumferential support element CSE is provided to support the edge region WER of the substrate W. The circumferential support element CSE comprises a peripheral set of protrusions PB to be placed against the edge region WER of the substrate W (shown in dashed lines in Figure 2). The peripheral set of protrusions PB of the embodiment of Figure 2 is arranged as a ring of protrusions PB such that all peripheral protrusions PB are placed at the same radius with respect to a center of the support plane SP. The peripheral protrusions PB are also arranged along an inwardly facing edge of the circumferential support element CSE such that the peripheral protrusions PB are adjacent to the outer protrusions B of the clamp body CB. In alternative embodiments, the peripheral set of protrusions PB may be arranged in any other suitable configuration on the circumferential support element CSE.

The circumferential support element CSE is movable with respect to the clamp body CB in a direction at least perpendicular to the support plane SP. In the embodiment shown in Figure 2 the circumferential support element CSE can move in two directions from a rest position, i.e. upwards and downwards.

The substrate support WT comprises one or more second electrodes ESC2 of a second electrostatic clamp to attract the movable circumferential support element CSE in a second clamping direction CLD2 opposite to the first clamping direction CLD1 such that the peripheral set of protrusions PB will be moved in the direction of or against the edge region WER of the substrate W supported on the substrate support WT during use. The circumferential support element CSE and the peripheral set of protrusions PB arranged thereon can be used to provide support to the edge region WER of the substrate W. The one or more second electrodes ESC2 may be embedded within the circumferential support element CSE as shown.

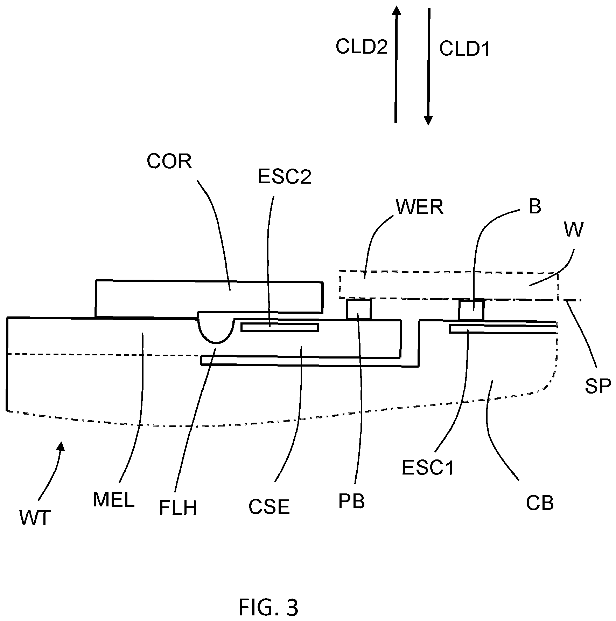

Figure 3 shows the circumferential support element CSE and the second electrostatic clamp having one or more second electrodes ESC2 in more detail. To allow the circumferential support element CSE to move in a direction at least perpendicular to the support plane SP the circumferential support element CSE is connected via a flexure hinge FLH to a mounting element MEL. The flexure hinge FLH has a low stiffness so that the stiffness of the flexure hinge FLH is of a small influence on the movement resulting from the electrostatic force exerted by the one or more second electrodes ESC2 of the second electrostatic clamp. Any other element or device to provide a flexible connection with low stiffness between the circumferential support element CSE and the mounting element MEL may also be applied. The circumferential support element CSE, flexure hinge FLH and mounting element MEL may be one integral part and may be made of a glass and/or ceramic material.

The mounting element MEL is a rigid body bonded to the clamp body CB. The mounting element MEL and the circumferential support element CSE may be formed integrally with the clamp body CB. In the embodiment of Figures 2 and 3, the circumferential support element CSE is biased in a rest position, wherein, in this rest position of the circumferential support element CSE and when no substrate W is supported on the burls B and the set of peripheral burls PB, support ends of the peripheral set of protrusions PB are arranged in the support plane SP, i.e. the protrusions B of the clamp body CB and the protrusions PB of the peripheral set of protrusions PB extend with their upper ends to the same height to define the support plane SP. In alternative embodiments, the circumferential support element CSE may be biased in a rest position, wherein, in this rest position of the circumferential support element CSE, support ends of the peripheral set of protrusions PB are arranged below or above the support plane SP.

On the mounting element MEL a counter element COR is fixed. The counter element COR is a rigid, ring shaped body fixed on the mounting element MEL. The counter element COR is therefore also in a fixed position with respect to the clamp body CB.

The counter element COR is made of a conductive material, for example SiSiC, silicon nitride, SiSiC infused with diamond or a ceramic material having some conductive coating on its side facing the one or more second electrodes ESC2. The counter element COR extends partially above the circumferential support element CSE at a distance that enables the one or more second electrodes ESC2 of the second electrostatic clamp to create an electrostatic attracting force between the circumferential support element CSE and the counter element COR. As a result of this electrostatic force, the circumferential support element CSE may be moved in the second clamping direction CLD2 towards the rigid counter element COR. The distance, or, gap, between the counter element COR and the circumferential support element CSE may in an embodiment be smaller than a height of the burls PB as shown in the figures, but in other embodiments said distance may be about the same as or greater than the height of the burls PB. The same holds for the distance, or gap, between the circumferential support element CSE and the clamp body CB.

An advantage of the electrostatic force being exerted during use by the second electrostatic clamp on the circumferential support element CSE is that the peripheral set of protrusions PB will be pulled against the edge region WER of the substrate W supported on the substrate support WT with a predetermined force instead of being in a fixed position. The predetermined force is substantially independent of the position at which the peripheral set of protrusions B will contact the substrate W, e.g. below, in or above the support plane SP (within the normal range of movement of the circumferential support element CSE). Thus, the position of the peripheral set of protrusions B is not determined by the support plane SP itself. A deviating thickness of the edge region WER of the substrate W, for example due to a deviating thickness of the backside coating and/or a warped shape of the edge region WER, has less effect on the support provided by the peripheral set of protrusions PB of the circumferential support element CSE.

Due to the low stiffness of the flexure hinge FLH, the predetermined force with which the peripheral set of protrusions B will be pulled against the substrate W mainly depends on the voltage applied to the one or more second electrodes ESC2 of the second electrostatic clamp.

The magnitude of the predetermined force, i.e. the applied voltage of the second electrode(s) ESC2 may be selected on the basis of the shape of the substrate W. This shape of the substrate W may be determined/known before loading of the substrate W on the substrate support WT, for example based on knowledge of the shape behavior of the substrate W. It is also possible to load the substrate W on the substrate support WT without applying any voltage on the second electrode(s) ESC2, measuring a height map of at least the edge region WER of the upper surface of the substrate W, and determining a voltage to be applied to the second electrode(s) ESC2 based on the determined height of at least the edge region WER of the substrate W.

When the height of the edge region WER varies along the circumference of the substrate W, for example when the substrate W has an undulating edge, the voltage to be applied to the second electrode(s) ESC2 may be adapted in dependence of the part of the substrate onto which a patterned EUV radiation beam is projected. For example, when the substrate front side, i.e. the upper side facing away from the clamp body CB at the edge region WER of the substrate W comprises, when clamped with the first electrostatic clamp, lower parts and higher parts, the voltage applied to the second electrode(s) ESC2 of the second electrostatic clamp ESC2 may be higher when the patterned EUV radiation beam is projected on or close to the lower parts of the edge region WER of the substrate W compared to the voltage applied to the second electrode(s) ESC2 of the second electrostatic clamp ESC2 when the patterned EUV radiation beam is projected on or close to the higher parts of the edge region WER of the substrate W. In this way both the lower parts and the higher parts of the substrate front side may be brought to substantially the same height, when the patterned EUV radiation beam is projected on or close to the respective parts of the edge region WER of the substrate W.

In the embodiment of Figures 2 and 3, the one or more electrodes ESC2 of the second electrostatic clamp are arranged on or in the circumferential support element CSE. In an alternative embodiment, the one or more electrodes ESC2 of the second electrostatic clamp may be arranged on or in the counter element COR. In yet another alternative embodiment, one or more electrodes may be arranged on or in the circumferential support element CSE and one or more counter electrodes may be arranged on or in the counter element COR.

In embodiments of the invention, the one or more electrodes ESC1 of the first electrostatic clamp may comprise one or more generally planar electrode sheets overlying the clamp body, wherein the plurality of burls B may be projecting from the clamp body through the one or more electrode sheets. In embodiments of the invention, the one or more electrodes ESC2 may comprise one or more generally planar electrode sheets overlying the circumferential support element.

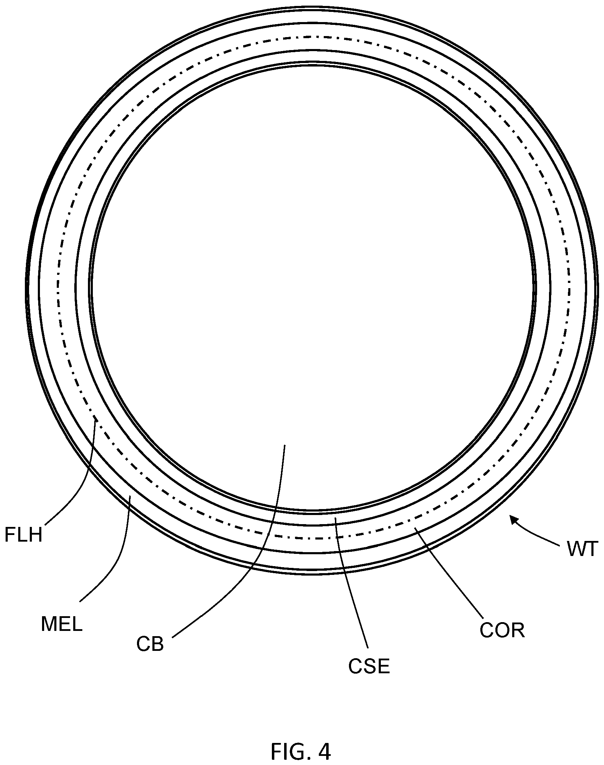

Figure 4 shows schematically a top view of the substrate support WT of Figure 2. In this embodiment, the circumferential support element CSE, the mounting element MEL and the counter element COR are all ring shaped elements. The flexure hinge FLH (depicted with a dashed line in Figure 4) is also ring shaped and extends over the complete circumference between the circumferential support element CSE and the mounting element MEL.

In other embodiments, the circumferential support element CSE, the mounting element MEL and/or the counter element COR may have two or more ring segments distributed around the circumference of the substrate support WT. Also, the flexure hinge FLH may be provided as multiple segments or connections between the circumferential support element CSE and the mounting element MEL, each segment or connection extending over a part of the circumference of the substrate support WT.

Loading of a substrate W on the substrate support WT shown in Figures 2-4 may involve the steps of arranging the substrate W on the clamp body CB, actuating the first electrostatic clamp to clamp the substrate W on the plurality of protrusions B, e.g. by applying a voltage to the first electrode(s) ESC1, and actuating the second electrostatic clamp to attract the circumferential support element CSE to support the edge region WER of the substrate W with the peripheral set of protrusions PB e.g. by applying a voltage to the second electrode(s) ESC2.

The step of loading the substrate W on the substrate support WT comprises for example placing a substrate W on lifting pins in extended positions and subsequently lowering the lifting pins to place the substrate on the protrusions B. After the substrate W is arranged on the protrusions B, the first electrostatic clamp may be actuated to clamp the substrate W on the protrusions B.

After the substrate W is clamped by the first electrostatic clamp, the edge region WER of the substrate W may be supported by the peripheral set of protrusions PB arranged on the circumferential support element CSE by actuating the second electrostatic clamp.

Before actuating the second electrostatic clamp, the upper surface of at least the edge region WER of the substrate may be measured to determine a height map of the edge region WER. The voltage applied to the second electrode(s) ESC2 of the second electrostatic clamp, may depend on the height map of the edge region WER of the substrate W as described above. In addition or as an alternative previously obtained data with respect to the shape of the substrate W, in particular the edge region WER may be used to determine the voltage to be applied to the second electrode(s) ESC2 of the second electrostatic clamp.

When desired, the voltage applied to the second electrode(s) ESC2 of the second electrostatic clamp may be adapted during the lithographic process in dependence of the part of the substrate W on which the patterned EUV radiation beam is projected, for example to bring lower and higher parts to substantially the same height as a main part of the substrate W when the patterned EUV radiation beam is projected on the respective parts of the substrate W.

In an alternative method of loading a substrate W on the substrate support WT, actuating the second electrostatic clamp is carried out before actuating the first electrostatic clamp in order to arrange the peripheral set of protrusions PB above the support plane SP. By arranging the peripheral set of protrusions PB above the support plane SP, the substrate W may, during lowering of the lifting pins, first be received by the peripheral set of protrusions PB before the substrate W lands on the protrusions B of the clamp body CB. In this way mechanical wear of the protrusions B of the clamp body CB may be reduced. As a result, the wear of the peripheral set of protrusions PB may increase, but this is less relevant as the peripheral set of protrusions PB is provided to arranged a predetermined force on the edge region WER of the substrate W instead of defining a flat support plane SP, such as the protrusions of the clamp body CB. Moreover, replacement of the circumferential support element CSE and peripheral set of protrusions PB may be more efficient than replacement of the complete clamp body CB with protrusions B.

Figure 7 shows an alternative embodiment of a substrate support WT comprising a first electrostatic clamp having one or more central electrodes ESC1A surrounded by one or more edge electrodes ESC1B. The central electrode(s) ESC1A may comprise one or more electrodes such as two half-circle shaped electrodes. The edge electrode(s) ESC1B may likewise comprise one or more electrodes, such as two half-annular shaped electrodes. The edge electrodes ESC1B may in an embodiment be provided radially outside the outer burl row of the plurality of burls B as shown. The edge electrodes ESC1B may be controlled independently of the central electrodes ESC1A.

Providing central electrode(s) ESC1A and edge electrodes ESC1B may be beneficial for loading substrates, in particular warped substrates. For example, in case of a so called umbrella shaped substrate W, the edge electrode electrodes ESC1B may provide an additional clamping force to the clamping force provided by the central electrodes ESC1A, so that in combination with a clamping force generated by the electrodes ESC2 of the second electrostatic clamp, a moment is applied at the edge region WER of the substrate W that forces the substrate W into a flat shape to a larger extent. So, in general, by providing a first electrostatic clamp ESC1 having central electrode(s) ESC1A as well as an edge electrode (s) ESC2B, in combination with the provision of the second electrostatic clamp ESC2, a substrate W may be flattened to an even larger extent.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A substrate support comprising:
a clamp body comprising a plurality of protrusions, the plurality of protrusions defining a support plane to support a substrate,
a first clamp to attract the substrate on the clamp body in a first clamping direction,
a circumferential support element comprising a peripheral set of protrusions to support an edge region of the substrate, wherein the circumferential support element is movable with respect to the clamp body in a direction at least perpendicular to the support plane,
a second clamp to attract the circumferential support element in a second clamping direction opposite to the first clamping direction such that the peripheral set of protrusions will be moved in the direction of or against the edge region of the substrate supported on the substrate support to support the edge region during use.

2. The substrate support of claim 1, wherein the second clamp is configured to pull the peripheral set of protrusions against the edge region of the substrate supported on the substrate support with a predetermined force.

3. The substrate support of claim 1 or 2, wherein the circumferential support element is biased in a rest position, wherein, in the rest position of the circumferential support element, upper ends of the peripheral set of protrusions are arranged in the support plane.

4. The substrate support of any of the claims 1-3, wherein the first clamp and the second clamp are electrostatic clamps.

5. The substrate support of any of the claims 1-4, wherein the circumferential support element is connected to the clamp body via a flexure hinge to allow the circumferential support element to move in the direction at least perpendicular to the support plane.

6. The substrate support of any of the claims 1-5, wherein the circumferential support element is a ring shaped element.

7. The substrate support of claim 6, wherein the circumferential support element is mounted on the clamp body via a ring shaped flexure hinge.

8. The substrate support of any of the preceding claims, wherein the second clamp comprises one or more electrodes on or in the circumferential support element and/or one or more electrodes arranged on or in a counter element rigidly connected to the clamp body.

9. The substate support of claim 8, wherein the counter element is a rigid ring element arranged at least partially above the circumferential support element.

10. The substrate support of any of the preceding claims, wherein the peripheral set of protrusions comprises a ring of protrusions.

11. A method for loading a substrate on the substrate support of any of the preceding claims, comprising:
arranging the substrate on the clamp body,
actuating the first clamp to clamp the substrate on the plurality of protrusions, and
actuating the second clamp to attract the circumferential support element to support the edge region of the substrate with the peripheral set of protrusions.

12. The method of claim 11, wherein actuating the first clamp is carried out before actuating the second clamp.

13. The method of claim 11, wherein actuating the second clamp is carried out before actuating the first clamp.

14. The method of any of the claims 11-13, wherein actuating the second clamp comprises moving the peripheral set of protrusions against the edge region of the substrate supported on the substrate support with a predetermined force.

15. A lithographic apparatus comprising the substrate support of any of the claims 1-10.
